# EUROPÄISCHE PATENTSCHRIFT

(11) **EP 0 818 684 B1**
(45) Veröffentlichungstag und Bekanntmachung des Hinweises auf die Patenterteilung: **16.04.2003**
(21) Anmeldenummer: 97111482.2
(22) Anmeldetag: 07.07.1997
(51) Int. Cl.: G01R 1/073

(54) **Vorrichtung zum Prüfen von elektrischen Leiterplatten**
Test system for printed circuits
Dispositif de test de circuits imprimés

(30) Priorität: 10.07.1996 DE 19627801
(43) Veröffentlichungstag der Anmeldung: 14.01.1998
(73) Patentinhaber: atg test systems GmbH & Co. KG, 97877 Wertheim (DE)
(72) Erfinder: Prokopp, Manfred, 97877 Wertheim-Reicholzheim (DE); Geier, Rudi, 97900 Külsheim-Hundheim (DE); Goldschmitt, Volker, 97877 Wertheim-Dörlesberg (DE)
(74) Vertreter: Ganahl, Bernhard

(56) Entgegenhaltungen:
- EP-A- 0 350 609
- DE-A- 3 717 528
- DE-C- 3 340 180

## Beschreibung

Die Erfindung betrifft eine Vorrichtung zum Prüfen von elektrischen Leiterplatten.

Vorrichtungen zum Prüfen von elektrischen Leiterplatten sind bspw. aus der US 3,564,408 bzw. der US 4,417,204 bekannt. Diese Vorrichtungen weisen eine Kontaktplatte auf, an der Prüfstifte in einem Grundraster angeordnet sind. Die Prüfstifte sind über lange Kabel mit einer Prüfschaltung verbunden. Die zu prüfenden Leiterplatten werden auf die Prüfplatte aufgelegt, wobei ein Adapter zwischen der Leiterplatte und der Prüfplatte angeordnet sein kann, so dass zwischen jedem Prüfpunkt der zu prüfenden Leiterplatte und einem Prüfstift ein elektrischer Kontakt hergestellt wird.

Ausgehend von dieser Art von Prüfvorrichtungen wurden modular aufgebaute Prüfvorrichtungen entwickelt, wie sie in den Patenten DE 32 40 916 C2 und DE 33 40 180 C1 beschrieben sind. Diese Art von Prüfvorrichtungen weisen eine Grundplatte auf, auf der vertikal angeordnete Module lagern, die jeweils einen Teil der elektronischen Prüfschaltung umfassen und an ihrem oberen Ende vertikal ausgerichtete Prüfstifte aufweisen. In einer Prüfvorrichtung werden mehrere derartige Module nebeneinander angeordnet, wobei die Anordnung der Prüfstifte ein die Kontaktplatte ersetzendes Kontaktfeld bildet. Für einen guten Zusammenhalt der Module kann eine Lochplatte auf die Prüfstifte aufgesetzt werden, wobei jeder Prüfstift ein Loch in der Lochplatte durchsetzt und so in seiner Lage fixiert ist.

Dieser modulare Aufbau des Kontaktfeldes hat sich sehr bewährt und in der Praxis durchgesetzt. Ein wesentlicher Vorteil dieses modularen Aufbaus ist, dass der Kontaktdruck, der beim Prüfen einer Leiterplatte angelegt wird, über die Module an die Grundplatte weitergeleitet wird. Nachteilig ist jedoch, dass bei einer Änderung des Rasters des Kontaktfeldes die gesamten Module ausgetauscht werden müssen. Deshalb ist man aus Kostengründen in der Anwendung im wesentlichen auf ein Grundraster festgelegt, das nur mit erheblichem finanziellen Aufwand verändert werden kann.

Die DE 3717528 A1 beschreibt ein Leiterplattenprüfgerät, das einen Rasteranpassungs-Adapter aufweist. Der Rasteranpassungs-Adapter besteht aus einem Paket Leiterplatten, die aneinanderliegend angeordnet und durch Isolierschichten getrennt sind. An zwei gegenüberliegenden Seiten des Paketes sind Module mit federnden Prüfkontakten angesetzt. Die Prüfkontakte weisen an jedem Modul einen Abstand von 1/10 Zoll (2,54 mm) auf. Die Leiterplatten des Rasteranpassungs-Adapters weisen eine Dicke von weniger als 1/20 Zoll auf und sind mit Leiterbahnen ausgebildet, die von den sich gegenüberliegenden Seiten des Paketes, an welchem die Module angeordnet sind, alle zu einer einzigen weiteren Seite des Paketes geführt sind und ein Prüfkontakt-Rasterfeld bilden. Auf das Prüfkontakt-Rasterfeld ist ein Verbindungs-Adapter und ein Off-grid-Adapter zum Kontaktieren einer zu prüfenden Leiterplatte aufgesetzt.

Aus der oben genannten DE 33 40 180 C1 geht zusätzlich eine Kontaktfeldanordnung für ein rechnergesteuertes Leiterplattenprüfgerät hervor. Das Kontaktfeld ist in Kontaktfeldabschnitte unterteilt, die jeweils für sich über längere Stützstreben gegen eine Grundplatte lösbar abgestützt sind. Der Raum zwischen den Stützstreben wird zur Unterbringung von Elektronikbauteilen genutzt, wobei die Einheit aus Stützstreben und Elektronikbauteilen als Kontaktfeldmodul bezeichnet wird. Der obere Abschnitt der Module weist Kontaktstifte auf, die in Löcher einer Lochplatte eingreifen und über einen Kontaktstecker und eine Klemmleiste mit den Elektronikbauteilen verbunden sind. Die Spitzen der Kontaktstifte bilden die einzelnen Kontaktpunkte der Kontaktfeldebene.

Aus der EP 0 350 609 A2 geht ein Leiterplattenprüfgerät hervor, das eine Grundplatte aufweist, die auf der zum Prüfling zugewandten Seite Kontaktflächen besitzt. In die Grundplatte sind Elektronikbausteine integriert.

Die EP 0 526 922 A2 beschreibt eine Vorrichtung zum Prüfen von bestückten Leiterplatten. Die Vorrichtung besitzt einen Receiver, der an einer zum Prüfling weisenden Seite Kontaktelemente aufweist, die mit einem entsprechenden Adapter in Kontakt bringbar sind. An der von dem Prüfling abweisenden Seite besitzt der Receiver ZIF-Stecker, an die Schaltungsmodule ansteckbar sind.

Aufgabe der Erfindung ist die Schaffung einer Vorrichtung zum Prüfen von elektrischen Leiterplatten, die flexibel in der Anwendung und kostengünstig in der Herstellung und in der Benutzung ist.

Die Aufgabe wird durch eine Prüfvorrichtung mit den Merkmalen des Anspruchs 1 gelöst. Vorteilhafte Ausgestaltungen sind in den Unteransprüchen angegeben.

Die Erfindung wird nachfolgend anhand der Zeichnungen beispielhaft näher erläutert. Es zeigen:
- Fig. 1: schematisch vereinfacht einen Bereich der erfindungsgemäßen Prüfvorrichtung im Querschnitt durch die Kontaktplatte,
- Fig. 2: schematisch vereinfacht einen Bereich einer weiteren Ausführungsform der erfindungsgemäßen Prüfvorrichtung im Querschnitt durch die Kontaktplatte,
- Fig. 3a und 3b: jeweils einen Bereich eines Kontaktfelds der Kontaktplatte der in Fig. 2 gezeigten Prüfvorrichtung in der Draufsicht.

Die erfindungsgemäße Prüfvorrichtung für Leiterplatten weist eine Kontaktplatte 1 auf, die vorzugsweise als Padfeldplatte mit mehreren als Kontaktelement dienenden Padfeldern 2 an ihrer Oberseite ausgebildet ist. Die Padfelder 2 sind an sich bekannte Goldplättchen, die einen guten Kontakt gewährleisten. Im Betrieb liegt auf der Kontaktplatte 1 ein Adapter mit Kontaktstiften auf, die mit den Padfeldem 2 in Berührung stehen.

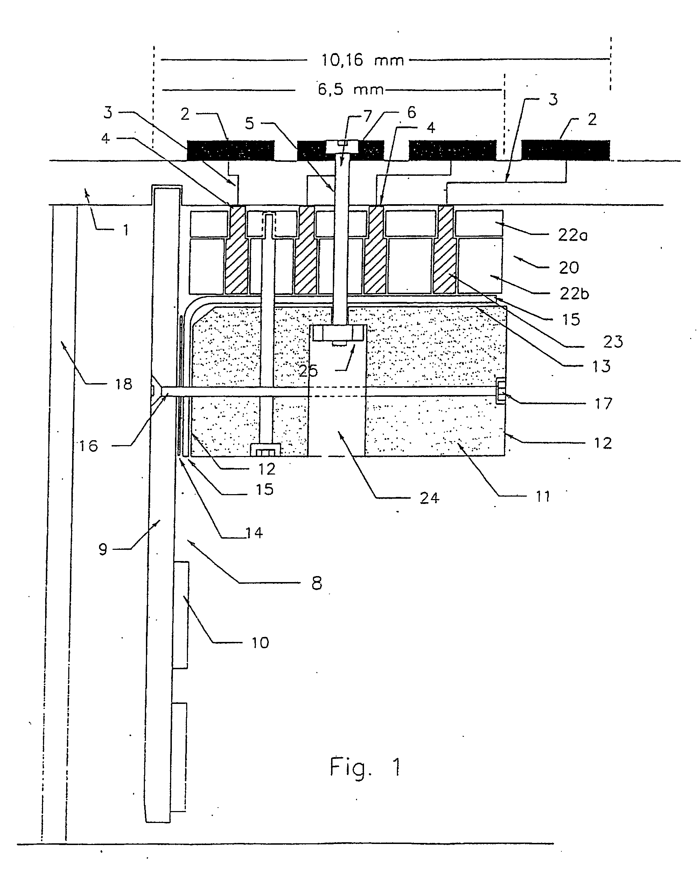

An der Unterseite der Kontaktplatte 1 sind Kontaktstellen 4 vorgesehen. Von jedem Padfeld 2 führt eine Leiterbahn 3 in der als Leiterplatte ausgebildeten Kontaktplatte 1 zu einer der Kontaktstellen 4, die sehr dicht aneinander angeordnet sein können. Die Kontaktstellen 4 sind vorzugsweise in Reihen gruppiert angeordnet, wobei in Fig. 1 ein Schnitt durch eine Gruppe von vier Reihen dargestellt ist. Durch die Ausbildung der Kontaktplatte 1 als Leiterplatte können die Padfelder 2 und die Kontaktstellen 4 voneinander unabhängig auf der Kontaktplatte 1 angeordnet werden.

In einer solchen Gruppe von Kontaktstellen 4 sind mittig in der Kontaktplatte vertikale Durchgangsbohrungen 5 eingebracht, die jeweils innerhalb eines Padfeldes 2, vorzugsweise mittig im Padfeld angeordnet sind. Im Bereich der Durchgangsbohrungen 5 sind in den Padfeldem 2 Senken 6 eingebracht, die zur Aufnahme von Schraubenköpfen von in den Durchgangsbohrungen lagernden Schrauben 7 dienen.

Mit den Schrauben 7 werden Elektronikeinheiten 8 an der Unterseite der Kontaktplatte 1 lösbar befestigt. Die Elektronikeinheiten 8 weisen eine vertikal ausgerichtete Schaltungskarte 9 mit elektronischen Bauteilen 10 auf, die zusammen einen Teil der Prüfschaltung bilden. Dieser Teil ist üblicherweise die Abtast- bzw. Scaneinrichtung, mit der die einzelnen Prüfpunkte der Leiterplatte der Reihe nach abgetastet werden.

Am oberen Endbereich der Schaltungskarte 9 ist eine Befestigungsleiste 11 an der Schaltungskarte 9 befestigt, die aus Kunststoff ausgebildet ist und einen rechteckigen Querschnitt mit zwei Schmalseitenwandungen 12 und zwei Breitseitenwandungen 13 aufweist. Die Befestigungleiste 11 ist mit einer Schmalseitenwandung 12 an die Schaltungskarte 9 geschraubt (Schrauben 16, Muttern 17), wobei zwischen der Schaltungskarte 9 und der Befestigungsleiste 11 ein Kontaktgummi 14 und eine Flexleitung 15 aneinanderliegend eingeklemmt sind. Der Kontaktgummi 14 ist zwischen der Schaltungskarte 9 und der Flexleitung 15 angeordnet. Die Flexleitung 15 ist eine biegsame Platte mit mehreren elektrischen Leitungen und entsprechenden Kontaktstellen.

An der Schaltungskarte 9 sind im Berührungsbereich mit dem Kontaktgummi 14 Kontaktstellen ausgebildet, wobei der Kontaktgummi 14 unter mechanischem Druck in Druckrichtung leitend ist, so dass er die Kontaktstellen der Schaltungskarte 9 und die Kontaktstellen der elektrischen Leitungen der Flexleitung 15 elektrisch miteinander verbindet. Die Flexleitung ist von der Schmalseitenwandung 12 zu der oberen Breitseitenwandung 13 geführt. Sie ist bspw. mittels einer Klebeverbindung an der Befestigungsleiste 11 befestigt.

Mit der oberen Breitseitenwandung 13 wird die Befestigungsleiste 11 an der Unterseite der Kontaktplatte 1 im Bereich der Kontaktstellen 4 befestigt, wobei zwischen der Flexleitung 15 und der Kontaktplatte 1 eine Kontaktfederleiste 20 (Fig. 1) angeordnet ist, um eine elektrische Verbindung zwischen der Flexleitung 15 und den Kontaktstellen 4 der Kontaktplatte 1 herzustellen. Die Kontaktfederleiste 20 ist aus zwei übereinander angeordneten Kunststoffleisten 22a, 22b ausgebildet, in welchen zu der Anordnung der Kontaktstellen 4 korrespondierende Durchgangsbohrungen eingebracht sind, in welchen Kontaktfedern 23 lagern. Die Kontaktfedern 23 sind im Bereich ihrer Mantelfläche abgestuft und bestehen aus einem elektrisch leitenden Metall. Sie sind jeweils zwischen einer Kontaktstelle 4 der Kontaktplatte 1 und einer Kontaktstelle der Flexleitung 15 eingespannt, so dass durch jede Kontaktfeder 23 eine elektrische Verbindung zwischen einer der Kontaktstellen 4 der Kontaktplatte 1 und einer elektrischen Leitung der Flexleitung hergestellt wird.

Die Schraube 7 bzw. die in Längsrichtung der Befestigungsleiste 11 verteilt angeordneten Schrauben 7 greifen jeweils in eine in einer Ausnehmung 24 in der Befestigungsleiste 11 eingesetzte Mutter 25 ein. Als Schrauben 7 werden kleine Uhrmacherschrauben verwendet.

Mit der Erfindung wird somit eine Kontaktplatte 1 geschaffen, an der eine oder mehrere Schaltungskarten lösbar befestigbar sind, wobei sowohl eine mechanische als auch eine elektrische Verbindung hergestellt wird. Es ist überraschend, dass eine lösbare Verbindung auf einfache Art und Weise realisiert werden kann, da zwischen den Padfeldem 2 kaum Platz vorhanden ist. Bei den erfindungsgemäßen Ausführungsbeispielen wurden deshalb die Mittel für die lösbare Verbindung - Uhrmacherschrauben - in den Padfeldem 2 platziert. Es hat sich überraschenderweise gezeigt, dass die Padfelder, in welchen die Schrauben angeordnet sind, einen ausreichend guten elektrischen Kontakt zu den Prüfstiften eines Adapters gewährleisten.

Die Ausbildung der Kontaktplatte 1 als Leiterplatte, wodurch sowohl die Padfelder 2 als auch die Kontaktstellen 4 frei angeordnet werden können, in Kombination mit dem Vorsehen einer lösbaren Verbindung zwischen der Kontaktplatte 1 und den Elektronikeinheiten 8 ermöglicht einen schnellen und kostengünstigen Austausch der Kontaktplatte 1, wobei die Rasterung bzw. Anordnung der Padfelder 2 bei Verwendung derselben Elektronikeinheiten 8 völlig frei gestaltet werden kann.

Zur Befestigung der Elektronikeinheiten 8 an der Kontaktplatte 1 werden Spannbügel verwendet, die die Elektronikeinheiten 8 in ihrer Stellung auf den Kontaktplatten spannen, so dass die Schrauben ohne Spannung angezogen werden können, wodurch sowohl die mechanische als auch die elektrische Verbindung fixiert wird.

Durch die lösbare mechanische und elektrische Verbindung werden wesentliche Vorteile erzielt:
- Das Vorsehen einer Kontaktplatte, die unabhängig von der Prüfelektronik ist, erlaubt durch einfachen Austausch der Kontaktplatte eine individuelle Anpassung des Rasters an die zu prüfende Leiterplatte. Es können somit an einer Prüfvorrichtung unterschiedliche Kontaktplatten mit unterschiedlichen Padfeldrastem eingesetzt werden, wobei jeweils dieselbe Elektronik verwendet wird.
- Die Kontaktplatte muss kein homogenes Raster aufweisen. Es ist bspw. ein Mischraster möglich, mit einem herkömmlichen Grundraster auf einem Teilbereich der Kontaktplatte, oder auch mit einem Raster mit doppelter Dichte auf dem anderen Teilbereich der Kontaktplatte.
- Die Geometrie der Kontaktplatte ist somit unabhängig von der Prüfelektronik.
- Es können relativ viele Kontaktstellen 4 in einem kleinen Bereich gruppiert werden, so dass mit einer einzigen Elektronikeinheit, die vorzugsweise eine hochintegrierte Schaltung aufweist, eine relativ große Fläche der Kontaktplatte bedient werden kann.

Die Erfindung ist selbstverständlich nicht auf Schrauben als Verbindungsmittel beschränkt, sondern es können auch Bolzen oder Spannelemente verwendet werden, mit welchen die Kontaktplatte und die Elektronikeinheiten zusammengehalten werden. Es können z.B. auch fest in die Kontaktplatte eingelassene Stifte vorgesehen sein, die an der Oberseite der Kontaktplatte abgedeckt sind. Zweckmäßig ist jedoch die Verwendung eines elektrisch leitenden Verbindungselements, das in den Padfeldem angeordnet ist, so dass das Verbindungselement zugleich als Kontaktelement für die Kontaktstifte eines Adapters dient.

Es hat sich ferner herausgestellt, dass durch die Gruppierung der Kontaktstellen 4, die bspw. in einem streifenförmigen Bereich mit einer Breite von 6,5 mm angeordnet sind (Fig. 1), an der Unterseite der Kontaktplatte 1 Zwischenraum zwischen den Elektronikeinheiten 8 und deren Verbindungsleisten geschaffen wird, in dem Stützplatten oder Stützstreben 18 angeordnet werden können, so dass eine Durchbiegung beim Prüfvorgang vollständig verhindert wird und die Elektronikeinheiten 8 mechanisch nicht belastet werden und von unten frei zugänglich sind.

Die Kontaktplatte kann auch in mehrere Segmente unterteilt sein, wobei die einzelnen Segmente in ein stabiles Gitter aus Stahl- oder Aluminiumstreben eingesetzt werden, so dass eine ausreichende Stabilität gewährleistet wird.

Die beiden oben beschriebenen Ausführungsbeispiele weisen zudem folgende Vorteile auf:
- Es wird eine lötfreie Verbindungstechnik erzielt.
- Es wird eine extrem hohe Kontaktdichte erzielt.
- Mechanische Verzüge werden durch die Kontaktgummis kompensiert.
- Es ist eine allgemein anwendbare, flexible und kostengünstige Verbindungstechnik.
- Die mit der Flexleitung in Verbindung stehenden Flächen der Kontaktplatte bzw. der Elektronikeinheit sind frei konfigurierbar, d.h. ihre Kontaktstellen sind frei anordbar.
- Die Anordnung der Elektronikeinheiten erfolgt in der dritten Dimension gegenüber der Kontaktplatte.

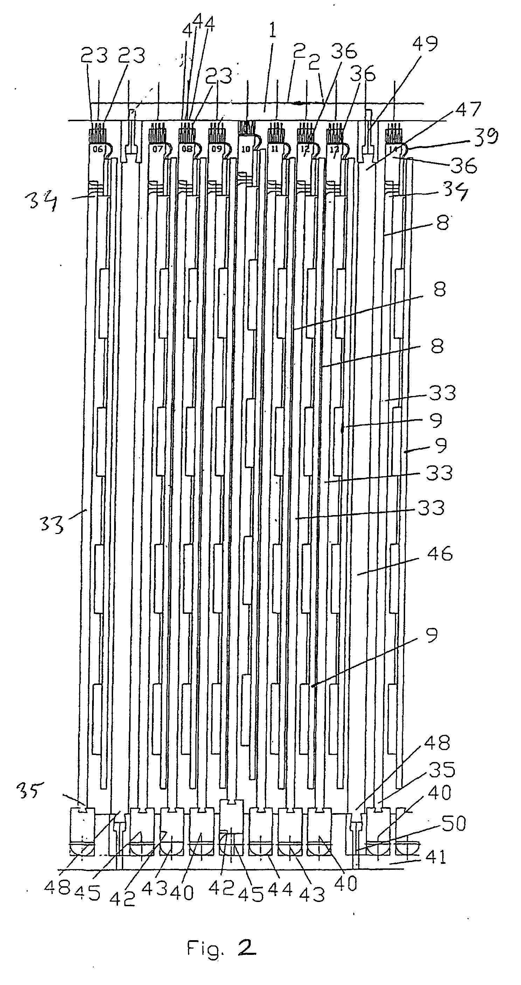

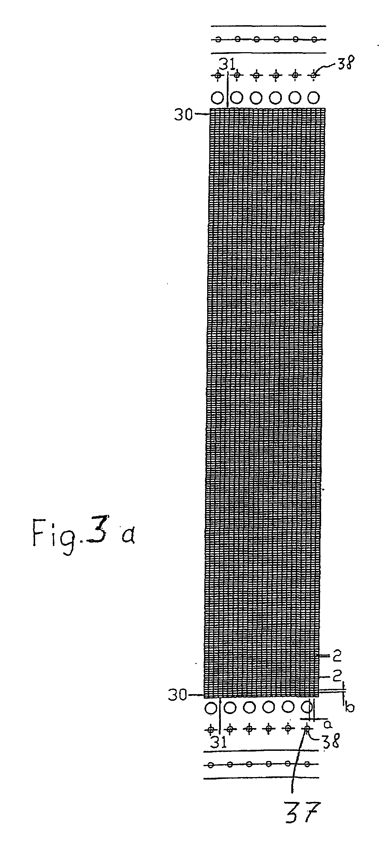

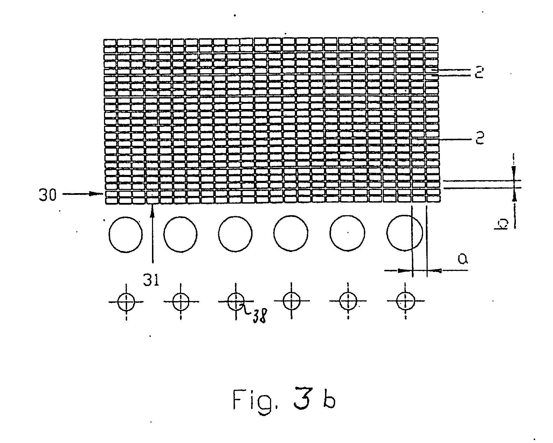

Ein weiteres Ausführungsbeispiel der erfindungsgemäßen Prüfvorrichtung ist in Fig. 2 und 3a, 3b gezeigt.

Diese Prüfvorrichtung weist wiederum eine als Leiterplatte ausgebildete Kontaktplatte 1 auf, die an ihrer Oberseite bzw. Prüfseite mit Padfeldem 2 versehen ist. Die Padfelder 2 bilden ein in Reihen 30 und Spalten 31 unterteiltes Kontaktfeld, wobei die einzelnen Spalten 31 einen Mittenabstand a von bspw. 1/10 Zoll (2,54 mm) und die Reihen 30 einen Mittenabstand b von 1/20 Zoll aufweisen, wodurch gegenüber herkömmlichen Kontaktplattenanordnungen mit einer 1/10 Zoll- Rasterung eine doppelte Padfelddichte erreicht wird.

An der Unterseite der Kontaktplatte 1 sind wiederum Kontaktstellen 4 ausgebildet, die jeweils mit einem Padfeld 2 über eine Leiterbahn (nicht dargestellt) verbunden sind.

Die Kontaktstellen 4 sind in Reihen gruppiert angeordnet, wobei jeder Reihe von Kontaktstellen eine Elektronikeinheit 8 zugeordnet ist. Die Elektronikeinheit 8 weist eine Andrückplatte 33 mit einer oberen horizontalen Kante 34 und einer unteren horizontalen Kante 35 auf. Die Andrückplatten 33 sind zur Kontaktplatte 1 senkrecht angeordnet, und über jeder Andrückplatte 33 ist eine Andrückleiste 36 vorgesehen, die mit der Andrückplatte 33 fest verbunden ist.

Auf der Oberseite der Andrückleisten 36 sind Kontaktfedern 23 vertikal befestigt. Im Randbereich sind an der Oberseite der Andrückleisten 36 Positionierstifte 37 angeordnet, die in entsprechende an der Unterseite der Kontaktplatte 1 eingebrachte Positionierbohrungen 38 eingreifen, so dass die Anordnung der Elektronikeinheiten 8 bezüglich der Kontaktplatte 1 festgelegt ist und die Kontaktfedem 23 auf jeweils eine Kontaktstelle 4 ausgerichtet sind.

An einer Seitenwandung der Andrückleisten 36 ist jeweils eine Schaltungskarte 9 mit ihrem oberen Rand befestigt, so dass sich die Schaltungskarten 9 nach unten, nicht ganz bis zur unteren Kante 35 der Andrückplatte 33 erstrecken. Die Schaltungskarten 9 sind vorzugsweise mit ihren elektronischen Bauteilen 10 zur Andrückplatte 33 zeigend angeordnet. Die Kontaktfedern 23 sind über elektrische Leitungen 39 im Bereich der Andrückleiste 36 mit den Schaltungskarten 9 elektrisch verbunden.

Die unteren Kanten 35 der Andrückplatten 33 sind als Schwalbenschwanz ausgebildet, wobei die Andrückplatten mit ihrem Schwalbenschwanz in entsprechend geformten Führungsnuten von Führungsleisten 40 lagern. Die Führungsleisten 40 sind an einer Grundplatte 41 in Nuten 42 vertikal verschiebbar eingebracht, wobei zwischen dem Nutboden und der Unterseite einer jeden Führungsleiste 40 ein Halbmondstab 43 angeordnet ist, der im Querschnitt die Form eines Halbkreises mit einer Bogenfläche 44 und einer Flachseitenfläche 45 hat.

Zum Einstecken und Herausnehmen einer Elektronikeinheit 8 ist der Halbmondstab 43 mit seiner Flachseitenfläche 45 horizontal ausgerichtet, so dass die Führungsleisten 40 tief unten in den Nuten 42 angeordnet sind. Durch Drehen des Halbmondstabes um 90°, so dass die Flachseitenflächen vertikal ausgerichtet sind, werden die Führungsleisten 40 aus den Nuten 42 etwas nach oben gedrückt, so dass auch die auf der jeweiligen Führungsleiste 40 lagernde Elektronikeinheit 8 nach oben gegen die Kontaktplatte 1 gedrückt wird. Hierdurch werden die Kontaktfedem 23 an die Kontaktstellen 4 gedrückt, so dass eine elektrische Verbindung hergestellt wird.

Um ein Durchbiegen der Kontaktplatte 1 nach oben zu verhindern, sind in regelmäßigen Abständen zwischen den Elektronikeinheiten 8 vertikal ausgerichtete Zugstreben bzw. Zugplatten 46 angeordnet. Die Zugplatten 46 sind an ihren oberen und unteren horizontalen Kanten 47, 48 jeweils als Schwalbenschwanz ausgebildet. Die als Schwalbenschwanz ausgebildeten Kanten 47, 48 lagern jeweils in einer oberen oder unteren schmalen Halteteiste 49, 50, wobei die Halteleisten entsprechende Nuten zur Aufnahme eines Schwalbenschwanzes aufweisen, so dass zwischen den Halteleisten einer Zugplatte 46 eine Zugspannung übertragen werden kann. Die obere Halteleiste 49 ist an die Unterseite der Kontaktplatte 1 befestigt und die untere Halteleiste 50 ist an die Grundplatte 41 befestigt, so dass die Zugplatten 46 die Kontaktplatte 1 und die Grundplatte 41 auf vorbestimmtem Abstand halten und der durch die Elektronikeinheiten 8 ausgeübten Spannung entgegenwirken.

Mit diesem Ausführungsbeispiel werden all die durch die lösbare Verbindung zwischen der Kontaktplatte 1 und den Elektronikeinheiten 8 und die Ausführung der Kontaktplatte 1 als Leiterplatte erzielten, oben beschriebenen Vorteile gleichermaßen erreicht. Zudem kann die Rasterung der als Kontaktelemente dienenden Padfelder 2 verkleinert werden, da die Padfelder 2 in ihrer Mindestgröße nicht durch eine Schraubenkopfgröße festgelegt sind. Es lassen sich somit einfach Kontaktplatten 1 mit einer doppelten oder vierfachen Padfelddichte gegenüber bekannten 1/10 Zoll-Rasterungen realisieren.

Die Zuordnung der Kontaktstellen 4 zu den Padfeldern 2 der in Fig. 3a und Fig. 3b gezeigten Kontaktplatte 1 erfolgt vorzugsweise so, dass die das Kontakifeld darstellenden Padfelder 2 aus acht nebeneinander angeordneten Spalten 31 mit denjenigen Kontaktstellen 4 elektrisch verbunden sind, die mit zwei Elektronikeinheiten 8 in Kontakt stehen. Den beiden Elektronikeinheiten 8 werden vollständige Reihen 30 der acht Spalten 31 zugeordnet, wobei die Reihen 30 jeweils abwechselnd den beiden Elektronikeinheiten 8 zugeordnet werden. Wird im Betrieb eine der beiden Elektronikeinheiten 8 weggelassen, so ist nur jede zweite Reihe 30 mit einer Elektronikeinheit 8 verbunden und damit funktionsfähig. Durch den "Ausfall" jeder zweiten Reihe 30 wird das mit doppelter Dichte ausgebildete Kontaktfeld nur mit einfacher Dichte betrieben. Somit lässt sich bei diesem Ausführungsbeispiel der erfindungsgemäßen Prüfvorrichtung nachträglich durch Hinzufügen oder Wegnehmen einer oder mehrerer Elektronikeinheiten 8 die effektive Dichte des Kontaktfeldes insgesamt oder auch nur bereichsweise variieren.

Alle oben beschriebenen Ausführungsbeispiele der Erfindung unterscheiden sich von den bekannten Prüfvorrichtungen dadurch, dass die elektrische Verbindung zwischen der Kontaktplatte 1 und den Elektronikeinheiten 8 alleine durch eine reine Druckverbindung zwischen den Kontaktstellen 4 und den Kontaktfedem 23 bzw. dem Kontaktgummi 21 hergestellt wird.

## Patentansprüche

1. Vorrichtung zum Prüfen von elektrischen Leiterplatten, mit einer Kontaktplatte (1), die als Leiterplatte ausgebildet ist und die an einer Prüfseite, der Oberoder Unterseite der Kontaktplatte, Kontaktelemente (2) aufweist, die in einem Raster in Reihen (30) und Spalten (31) angeordnet sind und mit Prüfpunkten der zu prüfenden Leiterplatte elektrisch leitend verbunden werden können, und an ihrer anderen Seite, der Unter- bzw. Oberseite der Kontaktplatte, Kontaktstellen (4) aufweist, die mit den Kontaktelementen (2) über Leiterbahnen (3) elektrisch verbunden sind, wobei an der die Kontaktstellen (4) aufweisenden Seite der Kontaktplatte (1) Elektronikeinheiten (8) mittels einer mechanischen Verbindung lösbar befestigt sind, wobei eine elektrische Verbindung zwischen den einen Teil einer Prüfschaltung aufweisenden Elektronikeinheiten (8) und den Kontaktstellen (4) hergestellt ist,
wobei eine Verbindungsleiste (11) vorgesehen ist, die zwei zueinander senkrecht angeordnete Wandungen (12, 13) aufweist, wobei an einer Wandung (12) eine der Elektronikeinheiten (8) und an der anderen Wandung (13) die Kontaktplatte (1) befestigt ist,
und auf den mit der Elektronikeinheit (8) und mit der Kontaktplatte (1) in Verbindung stehenden Wandungen (12, 13) der Verbindungsleiste (11) eine Flexleitung (15) angeordnet ist, die biegsam ist und mehrere elektrische Leitungen aufweist, wobei zwischen der Flexleitung (15) und der Kontaktplatte (1) eine Kontaktfederleiste (20) angeordnet ist, so dass zwischen den elektrischen Leitungen der Flexleitung (15) und den Kontaktstellen (4) der Kontaktplatte (1) je eine elektrisch leitende Verbindung hergestellt ist, wobei die Kontaktfederleiste (20) mehrere elektrisch leitende Kontaktfedern enthält, die zwischen den Kontaktstellen der Kontaktplatte (1) und der Flexleitung (15) gespannt sind.

2. Vorrichtung nach Anspruch 1,
**dadurch gekennzeichnet,**
**dass** die Kontaktstellen (4) in einen oder mehrere Teilbereiche der Kontaktplatte (1) gruppiert angeordnet sind.

3. Vorrichtung nach Anspruch 1 oder 2,
**dadurch gekennzeichnet,**
**dass** die Kontaktplatte (1) mit den Elektronikeinheiten (8) mittels Verbindungselementen verbunden ist, die aus einem elektrisch leitenden Material bestehen und innerhalb eines Kontaktelementes der Kontaktplatte (1), das vorzugsweise ein Padfeld (2) ist, angeordnet sind.

4. Vorrichtung nach Anspruch 3,
**dadurch gekennzeichnet,**
**dass** die Verbindungselemente Schrauben (7) sind, die in Durchgangsbohrungen (5) der Kontaktplatte (1) lagern.

5. Vorrichtung nach Anspruch 3,
**dadurch gekennzeichnet,**
**dass** die Verbindungselemente mechanische Spannelemente sind.

6. Vorrichtung nach einem der Ansprüche 1 bis 5,
**dadurch gekennzeichnet,**
**dass** die Elektronikeinheiten (8) mittels einer Schraubverbindung an der Verbindungsleiste (11) befestigt sind.

7. Vorrichtung nach einem der Ansprüche 1 bis 6,
**dadurch gekennzeichnet,**
**dass** zwischen der Flexleitung (15) und der Elektronikeinheit (8) ein Kontaktgummi (14) angeordnet ist, so dass zwischen den elektrischen Leitungen der Flexleitung (15) und der Elektronikeinheit (8) je eine elektrisch leitende Verbindung hergestellt ist.

8. Vorrichtung nach einem der Ansprüche 1 bis 7,
**dadurch gekennzeichnet,**
**dass** die Kontaktplatte (1) in mehrere Segmente unterteilt ist, wobei die Segmente vorzugsweise in ein stabiles Gitter aus Stahl- oder Aluminiumstreben eingesetzt sind.

9. Vorrichtung nach einem der Ansprüche 1 bis 8,
**dadurch gekennzeichnet,**
**dass** die Kontaktplatte (1) durch Stützstreben bzw. Stützplatten von unten unterstützt wird.

10. Vorrichtung nach Anspruch 1 oder 2,
**dadurch gekennzeichnet,**
**dass** die Elektronikeinheiten (8) eine Andrückplatte (33) aufweisen, die sich an einer Grundplatte (41) abstützt und eine Andrückleiste (36) mit an der Andrückleiste (36) angeordneten Kontaktfedern (23) gegen die Kontaktstellen (4) der Kontaktplatte (1) drückt.

11. Vorrichtung nach Anspruch 10,
**dadurch gekennzeichnet,**
**dass** an der Andrückleiste (36) eine Schaltungskarte (9) befestigt ist, die mit den Kontaktfedern (23) in elektrischer Verbindung steht.

12. Vorrichtung nach Anspruch 10 oder 11,
**dadurch gekennzeichnet,**
**dass** die Elektronikeinheiten (8) durch Positionierstifte (37) und korrespondierende Positionierbohrungen (38) der Kontaktplatte (1) ausgerichtet sind.

13. Vorrichtung nach einem der Ansprüche 10 bis 12,
**dadurch gekennzeichnet,**
**dass** zwischen der Andrückplatte (33) und der Grundplatte (41) ein Druckmechanismus, bspw. in Form eines Halbmondstabes (43), angeordnet ist, mit dem die Andrückplatte (33) in Richtung zur Kontaktplatte (1) mit einer Druckkraft beaufschlagt werden kann.

14. Vorrichtung nach einem der Ansprüche 10 bis 13,
**dadurch gekennzeichnet,**
**dass** in regelmäßigen Abständen zwischen den Elektronikeinheiten (8) senkrecht zur Kontaktplatte (1) ausgerichtete Zugstreben bzw. Zugplatten (46) angeordnet sind, die die Kontaktplatte (1) mit der Grundplatte (41) derart verbinden, dass sie eine zwischen den Platten (1, 41) auftretende Zugspannung aufnehmen können.

15. Vorrichtung nach einem der Ansprüche 10 bis 14,
**dadurch gekennzeichnet,**
**dass** in einem Bereich der Kontaktplatte die Reihen (30) bzw. die Spalten (31) abwechselnd an eine von zwei Elektronikeinheiten (8) angeschlossen sind.

## Claims

1. A tester for testing electric circuit boards comprising
a contact board (1) configured as a circuit board featuring on a test side, the upper or lower side of the contact board, contact elements (2) arranged in a grid in rows (30) and columns (31) and capable of being electrically conductively connected to test points of the circuit board to be tested, and on its other side, the lower or upper side of the contact board, having contact points (4) electrically connected to the contact elements (2) via conductors (3), wherein electronic units (8) are releasably secured by a physical connection to the side of the contact board (1) having the contact points (4), wherein an electrical connection is made between the electronic units (8) comprising one part of a test circuit and the contact points (4),
wherein a connecting strip (11) having two walls (12, 13) arranged at right-angles to one another is provided, with one of the electronic units (8) secured to one wall (12) and the contact board (1) being secured to the other wall (13),
and on the walls (12, 13) of the connecting strip (11) connected to the electronic unit (8) and the contact board (1) there is arranged a flex conductor (15) which is flexible and has several electrical leads, wherein a receptacle connector (20) is provided between the flex conductor (15) and the contact board (1) so that an electrically conductive connection is made between the electrical leads of the flex conductor (15) and the contact points (4) of the contact board (1), wherein the receptacle connector (20) contains several electrically conductive contact springs which are clamped between the contact points of the contact board (1) and the flex conductor (15).

2. The tester as set forth in claim 1,
**characterised in that** said contact points (4) are arranged grouped in one or more partial portions of said contact board (1).

3. The tester as set forth in claim 1 or 2,
**characterised in that** said contact board (1) is connected to said electronic units (8) by means of connecting elements made of an electrically conductive material and arranged within a contact element of said contact board (1) which is preferably a pad field (2).

4. The tester as set forth in claim 3,
**characterised in that** said connecting elements are screws (7) mounted in through--holes (5) of said contact board (4).

5. The tester as set forth in claim 3,
**characterised in that** said connecting elements are physical tensioning elements.

6. The tester as set forth in any of claims1 to 5,
**characterised in that** said electronic units (8) are secured by means of a further screw connection to said connecting strip (11).

7. The tester as set forth in any of claims1 to 6,
**characterised in that** between said flex conductor (15) and said electronic unit (8) a rubber contact element (14) is arranged so that between said electrical leads of said flex conductor (15) and said electronic unit (8) an electrically conductive connection is produced.

8. The tester as set forth in any of claims 1 to 7,
**characterised in that** the contact board (1) is divided into several segments inserted preferably in a rugged grid of steel or aluminium struts.

9. The tester as set forth in any of claims 1 to 8,
**characterised in that** said contact board (1) is supported from underneath by supporting struts or supporting boards.

10. The tester as set forth in claim 1 or 2,
**characterised in that** said electronic units (8) comprise a pressure board (33)supported by a mother-board (41) and urging a pressure strip (36) having contact springs (23) arranged on said pressure strip (36) against said contact points (4) of said contact board (1).

11. The tester as set forth in claim 10,
**characterised in that** a circuit card (9) is secured to said pressure strip (36), said circuit card being electrically connected to said contact springs (23).

12. The tester as set forth in claim 10 or 11,
**characterised in that** said electronic units (8) are oriented by positioning pins (37) and corresponding positioning holes (38) on said contact board (1).

13. The tester as set forth in any of claims 10 to 12,
**characterised in that** a pressure mechanism, for example in the form of a crescent rod (43) is arranged between said pressure board (33) and said mother-board (41), said pressure board (33) being capable of receiving a pressure force from said crescent rod acting in the direction of the contact board (1).

14. The tester as set forth in any of claims 10 to 13,
**characterised in that** tension struts or tension boards (46) are arranged at regular intervals between said electronic units (8) at right-angles to the contact board (1), said tension struts or tension boards connecting said contact board (1) to said mother-board (41) such that tension occurring between said boards (1, 41) is accommodated.

15. The tester as set forth in any of claims10 to 14,
**characterised in that** in a portion of said contact board, the rows (30) and columns (31) are connected alternately to one of two electronic units (8).

## Revendications

1. Dispositif de test de plaques de circuits imprimés électriques comportant une plaque de contact (1) qui est conformée en plaque de circuits imprimés et qui comporte sur une face de test, la face supérieure ou la face inférieure de la plaque de contact, des éléments de contact (2) qui sont agencés suivant une trame constituée de rangées (30) et de colonnes (31) et qui peuvent être raccordés électriquement à des points de test de la plaque de circuits imprimés à tester, et qui comporte sur son autre face, la face inférieure resp. supérieure de la plaque de contact, des emplacements de contact (4) qui sont raccordés électriquement aux éléments de contact (2) via des pistes conductrices (3),
dans lequel des unités électroniques (8) sont fixées de façon amovible au moyen d'une liaison mécanique sur la face de la plaque de contact (1) qui comporte les emplacements de contact (4),
dans lequel une liaison électrique est réalisée entre les unités électroniques (8) comportant une partie d'un circuit de test et les emplacements de contact (4), dans lequel il est prévu une barre de liaison (11) qui comporte deux parois (12, 13) agencées perpendiculairement l'une à l'autre,
dans lequel l'une des unités électroniques (8) est fixée à une paroi (12) et la plaque de contact (1) est fixé à l'autre paroi (13), et il est agencé sur les parois (12, 13), en liaison avec l'unité électronique (8) et la plaque de contact (1), de la barre de liaison (11) un câble souple (15) qui est pliable et qui comporte plusieurs lignes électriques,
dans lequel il est agencé une barrette de ressorts de contact (20) entre le câble souple (15) et la plaque de contact (1) de sorte qu'il est réalisé à chaque fois une liaison électroconductrice entre les lignes électriques du câble souple (15) et les emplacements de contact (4) de la plaque de contact (1), la barrette de ressorts de contact (20) contenant plusieurs ressorts de contact électroconducteurs qui sont contraints entre les emplacements de contact de la plaque de contact (1) et le câble souple (15).

2. Dispositif selon la revendication 1, **caractérisé en ce que** les emplacements de contact (4) sont agencés de façon groupée dans une ou plusieurs sous-régions de la plaque de contact (1).

3. Dispositif selon la revendication 1 ou 2, **caractérisé en ce que** la plaque de contact (1) est reliée aux unités électroniques (8) au moyen d'éléments de liaison qui sont constitués d'un matériau électroconducteur et qui sont agencés à l'intérieur d'un élément de contact de la plaque de contact (1) qui est de préférence une pastille (2).

4. Dispositif selon la revendication 3, **caractérisé en ce que** les éléments de liaison sont des vis (7) qui sont montées dans des alésages traversants (5) de la plaque de contact (1).

5. Dispositif selon la revendication 3, **caractérisé en ce que** les éléments de liaison sont des éléments de serrage mécaniques.

6. Dispositif selon l'une des revendications 1 à 5, **caractérisé en ce que** les unités électroniques (8) sont fixées à la barre de liaison (11) au moyen d'une liaison par vis.

7. Dispositif selon l'une des revendications 1 à 6, **caractérisé en ce qu'**un caoutchouc de contact (14) est disposé entre le câble souple (15) et l'unité électronique (8) de sorte qu'il est réalisé à chaque fois une liaison électroconductrice entre les lignes électriques du câble souple (15) et l'unité électronique (8).

8. Dispositif selon l'une des revendications 1 à 7, **caractérisé en ce que** la plaque de contact (1) est divisée en plusieurs segments, les segments étant de préférence insérés dans une grille stable constituée de montants en acier ou en aluminium.

9. Dispositif selon l'une des revendications 1 à 8, **caractérisé en ce que** la plaque de contact (1) est soutenu depuis le dessous par des montants d'appui ou des plaques d'appui.

10. Dispositif selon la revendication 1 ou 2, **caractérisé en ce que** les unités électroniques (8) comportent une plaque de pressage (33) qui s'appuie sur une plaque de base (41) et qui presse une barre de pressage (36) contre les emplacements de contact (4) de la plaque de contact (1) au moyen de ressorts de contact (23) agencés sur la barre de pressage (36).

11. Dispositif selon la revendication 10, **caractérisé en ce qu'**une carte de circuits (9), qui est reliée électriquement à des ressorts de contact (23), est fixée à la barre de pressage (36).

12. Dispositif selon la revendication 10 ou 11, **caractérisé en ce que** les unités électroniques (8) sont alignées par des picots de positionnement (37) et des alésages de positionnement correspondants (38) de la plaque de contact (1).

13. Dispositif selon l'une des revendications 10 à 12, **caractérisé en ce qu'**il est agencé entre la plaque de pressage (33) et la plaque de base (41) un mécanisme de pression, par exemple sous la forme d'une tige en demi-lune (43), au moyen duquel la plaque de pressage (33) peut être sollicitée en direction de la plaque de contact (1) avec une force de pression.

14. Dispositif selon l'une des revendications 10 à 13, **caractérisé en ce qu'**il est agencé à des distances régulières entre les unités électroniques (8) des montants de traction ou des plaques de traction (46), orientés perpendiculairement à la plaque de contact (1), qui relient la plaque de contact (1) à la plaque de base (41) de telle sorte qu'elles peuvent recevoir une effort de traction apparaissant entre les plaques (1, 41).

15. Dispositif selon l'une des revendications 10 à 14, **caractérisé en ce que** les rangées (30), respectivement les colonnes (31), sont raccordées alternativement à l'une des deux unités électroniques (8) dans une région de la plaque de contact.
